# FASCICULE DE BREVET EUROPEEN

(11) **EP 3 800 658 B1**
(45) Date de publication et mention de la délivrance du brevet: **31.05.2023**
(21) Numéro de dépôt: 20199549.5
(22) Date de dépôt: 01.10.2020
(51) Int. Cl.: H01L 21/02, H01L 21/18, H01L 21/04

(54) **PROCÉDÉ DE FABRICATION D'UN DISPOSITIF ÉLECTRONIQUE**
VERFAHREN ZUR HERSTELLUNG EINER ELEKTRONISCHEN VORRICHTUNG
METHOD FOR MANUFACTURING AN ELECTRONIC DEVICE

(30) Priorité: 04.10.2019 FR 1910990
(43) Date de publication de la demande: 07.04.2021
(73) Titulaire: Commissariat à l'Energie Atomique et aux Energies Alternatives, 75015 Paris (FR)
(72) Inventeur: NASER, Hasan, 38054 GRENOBLE Cedex 9 (FR)
(74) Mandataire: Hautier IP

(56) Documents cités:
- EP-A1- 3 229 260
- US-A1- 2011 101 445
- US-B1- 8 373 175

## Description

### DOMAINE TECHNIQUE

La présente invention concerne le domaine de l'électronique en général et des dispositifs micro-électroniques. Elle trouve pour application particulièrement avantageuse le domaine des transistors de puissance, cet exemple n'étant pas limitatif. Toute application mettant en oeuvre du carbure de silicium et nécessitant une conductivité électrique verticale est ouverte à l'invention.

D'une manière générale, l'invention peut servir dans tous dispositifs micro-électroniques.

### ÉTAT DE LA TECHNIQUE

Dans le cas des transistors de puissance fonctionnant en vertical (c'est-à-dire suivant la dimension en épaisseur des substrats), un collage de matériaux semi-conducteurs avec une couche conductrice enterrée est d'un intérêt majeur pour des applications micro-électroniques. Afin de réaliser cet assemblage, une solution technique est le transfert de films minces de carbure de silicium (SiC) monocristallin sur un substrat, notamment de carbure de silicium polycristallin, via un collage électriquement conducteur.

C'est dans ce contexte que s'inscrit la publication brevet US 7208392 B1 qui montre, dans le cas des figures 6A à 6D, parmi différentes réalisations, l'obtention d'un report d'un film mince de carbure de silicium sur un substrat plus massif, également de carbure de silicium. Une mise en oeuvre de couches métalliques, en titane, réalise un collage lors d'un report de couches. Une technique de clivage au niveau d'une zone fragilisée permet selon ce document de ne laisser subsister sur le dispositif final que le film mince de carbure de silicium.

Les contraintes techniques de ce procédé de report de couches de carbure de silicium avec collage s'avèrent malgré tout très fortes. Notamment, généralement, il faudra que le collage soit stable dans des conditions d'épitaxie du carbure de silicium de l'ordre de 1700°C et lors des différentes étapes du procédé, par exemple le clivage du film mince, typiquement entre 800°C et 900°C. Il convient donc de disposer d'un collage assurant la plus faible résistivité électrique possible tout en étant compatible avec les conditions de formation de couches de carbure de silicium (épitaxie, clivage). Dans ce contexte, la technique actuelle révèle des limitations, notamment par la formation de phases chimiques dégradant la fonctionnalité de la structure souhaitée : phase liquide, phase solide parasite, cavités, etc.

Il convient par ailleurs de préciser qu'il existe, notamment au sein de la demande de brevet EP3229260A1, un procédé de fabrication d'un dispositif électronique par empilement comprenant un substrat en un matériau semi-conducteur, une portion intermédiaire et une couche de carbure de silicium. Le procédé décrit également un transfert de la couche de carbure de silicium depuis un premier élément électronique sur une face d'un deuxième élément électronique comprenant le substrat.

Cependant ce procédé ne semble pas permettre de garantir une stabilité thermodynamique élevée, par exemple jusqu'à une gamme de température d'au moins 1900 °C.

Un objet de la présente invention est donc de proposer une méthode et un dispositif résultant qui permettent d'obtenir des structures thermodynamiquement stables tout en disposant d'un niveau de conductivité électrique (et éventuellement thermique) satisfaisant.

Les autres objets, caractéristiques et avantages de la présente invention apparaîtront à l'examen de la description suivante et des dessins d'accompagnement. Il est entendu que d'autres avantages peuvent être incorporés.

### RÉSUMÉ

Pour atteindre cet objectif, selon un mode de réalisation, on prévoit un procédé de fabrication d'un dispositif électronique comportant en empilement un substrat en matériau semi-conducteur, une portion intermédiaire et une couche de carbure de silicium, le procédé comprenant un transfert de la couche de carbure de silicium depuis un premier élément électronique sur une face d'un deuxième élément électronique comprenant le substrat, le transfert comprenant :
- une fourniture du premier élément comprenant en empilement une couche primaire à base de carbure de silicium, une première portion de barrière de diffusion et une première couche métallique ;
- une fourniture du deuxième élément comprenant en empilement le substrat, une deuxième portion de barrière de diffusion et une deuxième couche métallique
- un collage d'une face exposée de la première couche métallique et d'une face exposée de la deuxième couche métallique.

Selon l'invention:
∘ la première couche métallique et la deuxième couche métallique sont formées en tungstène;
∘ la première portion est formée d'au moins une couche d'un siliciure de tungstène;
∘ la deuxième portion est formée d'au moins une couche d'un siliciure de tungstène,
∘ la deuxième portion de barrière de diffusion, la deuxième couche métallique, la première couche métallique et la première portion de barrière de diffusion formant la portion intermédiaire.

Ainsi, on obtient un collage efficace avec une continuité électrique élevée entre le substrat et la couche à base de carbure de silicium. Cela assure un empilement final stable même à température élevée avec une forte conductivité électrique verticale.

Alors que la présence de couche(s) de siliciure de tungstène aurait pu a priori apparaitre comme défavorable à la conductivité de l'empilement produit, relativement au tungstène seul en particulier, cette présence maitrisée (ces couches sont volontairement fabriquées, donc notamment d'épaisseurs réduites et réglables sans difficulté technique) permet, au contraire de ce préjugé, d'obtenir un empilement stable en terme de composition, car peu ou pas sensible aux diffusions d'espèces lors d'étapes technologiques à budget thermique élevé ; tout ceci en assurant une bonne conductivité verticale d'un point de vue électrique.

De manière avantageuse, l'empilement est thermodynamiquement stable, c'est-à-dire qu'il n'y a pas de réactivité chimique significative entre les différentes couches durant les différentes étapes de réalisation.

Un autre aspect concerne un dispositif électronique comprenant en empilement un substrat à base de matériau semi-conducteur, une portion intermédiaire, et une couche à base de carbure de silicium, la portion intermédiaire comprenant successivement au moins une première couche de siliciure de tungstène, une couche de tungstène et au moins une deuxième couche de siliciure de tungstène.

Un tel dispositif offre un empilement de couches favorable à des étapes technologiques ultérieures, notamment lorsque des températures élevées sont en jeu. La conductivité électrique au travers de l'empilement est améliorée, en particulier relativement à des empilements sans recours à du tungstène et à des siliciures de ce métal.

Un autre aspect, qui n'entre pas dans le cadre des revendications , est relatif à un élément électronique comprenant en empilement une couche de carbure de silicium, une portion de barrière de diffusion et une couche de tungstène, la portion de barrière de diffusion comprenant successivement une couche de WSi₂ et une couche de W₅Si₃.

Cet élément présente une succession de couches de siliciure de tungstène choisies de manière précise pour coopérer avec les couches environnantes. En effet, la couche faite de WSi₂ forme une première barrière entre le carbure de silicium et la deuxième couche de siliciure, faite de W₅Si₃. Cette dernière a pour rôle de séparer le tungstène pur du WSi₂, afin d'empêcher sa décomposition. Un aspect avantageux est l'utilisation d'un tel élément, et de préférence d'un système d'un premier et d'un deuxième élément, pour le report d'une couche de carbure de silicium avec une couche de collage en tungstène.

Ainsi, contrairement à la demande de brevet EP3229260A1 et grâce aux portions de barrières de diffusion, une stabilité thermodynamique élevée est garantie, par exemple mais non limitativement jusqu'à une gamme de température d'au moins 1900°C, et possiblement entre 25°C et 1900°C. En effet , l'existence d'une portion de barrière de diffusion formée d'au moins une couche d'un siliciure de tungstène entre la première couche métallique et la couche primaire et d'une portion de barrière de diffusion formée d'au moins une couche d'un siliciure de tungstène entre la deuxième couche métallique et le substrat, contribue à la méthode permettant d'obtenir des structures thermodynamiquement stables tout en disposant d'un niveau de conductivité électrique satisfaisant.

### BRÈVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
La figure 1 représente un premier mode de réalisation d'un élément électronique.
La figure 2 représente un deuxième mode de réalisation d'un élément électronique.
Les figures 3A à 3D représentent un exemple d'étapes de mise en oeuvre du procédé.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques.

### DESCRIPTION DÉTAILLÉE

Avant d'entamer une revue détaillée de modes de réalisation de l'invention, sont énoncées ci-après des caractéristiques optionnelles qui peuvent éventuellement être utilisées en association ou alternativement :
- au moins une des couches de siliciure de tungstène est une couche d'un matériau choisi parmi du WSi₂ et du W₅Si₃ ;
- la première portion est formée au moins d'une couche de W₅Si₃ 12.
- la couche de W₅Si₃ 12 de la première portion est au contact de la première couche métallique 14 ;
- la première portion est aussi formée d'une couche de WSi₂ 13 entre la couche primaire 11 et la couche de W₅Si₃ 12 de la première portion ;
- la deuxième portion est formée au moins d'une couche de W₅Si₃ 22.
- la couche de W₅Si₃ 22 de la deuxième portion est au contact de la deuxième couche métallique 24 ;
- la deuxième portion est aussi formée d'une couche de WSi₂ 23 entre le substrat 21 et la couche de W₅Si₃ 22 de la deuxième portion ;
- au moins une couche d'un siliciure de tungstène d'au moins l'une parmi la première portion et la deuxième portion est choisie avec une épaisseur inférieure ou égale à 20nm et/ou supérieure ou égale à 5nm ;
- au moins une couche d'un siliciure de tungstène d'au moins l'une parmi la première portion et la deuxième portion est formée par co-pulvérisation de molécules de W et de molécules de Si ;
- le collage comprend un collage direct avec activation de surface ;
- l'activation de surface est configurée pour désoxyder, au moins partiellement, la face exposée 141 d'au moins l'une parmi la première couche métallique 14 et la deuxième couche métallique 24 ;
- le substrat 21 est en carbure de silicium ;
- Le procédé comprend la formation d'une zone de fragilisation 111 dans la couche primaire par une implantation d'espèces chimiques et, après le collage, un clivage de la couche primaire au niveau de la zone de fragilisation 111 par application d'un recuit.

Avantageusement, le substrat 21 est en carbure de silicium, ce qui n'exclut pas que d'autres portions ou couches, notamment en d'autres matériaux, soient rapportées sur la face inférieure de ce dernier.

De préférence, la première portion de barrière de diffusion et/ou la deuxième portion de barrière de diffusion est faite uniquement de la couche de WSi₂ ou de W₅Si₃, ou de la paire de couches respectivement faites de WSi₂ et de W₅Si₃.

De préférence, au moins l'une parmi la première portion et la deuxième portion comprend successivement, entre une couche de carbure de silicium et une couche de tungstène, une couche de WSi₂ et une couche de W₅Si₃.

De préférence, les empilements ne comprennent pas d'autres couches que les couches de siliciure de tungstène entre le substrat semi-conducteur/couche primaire de carbure de silicium, et les couches métalliques de tungstène.

Avantageusement, la couche primaire est utilisée pour former la couche de carbure de silicium reportée, avec une séparation d'une portion de la couche primaire, de sorte à ne reporter qu'une couche, plus mince que la couche primaire, sur l'élément électronique qui comporte le substrat. Cependant, il n'est pas exclu que l'ensemble de la couche primaire forme la couche de carbure de silicium rapportée après collage. De même, il n'est pas exclu que d'autres couches soient présentes sur le premier élément, en particulier sur la face de la couche primaire opposée à la première couche métallique.

À titre préféré, la couche de carbure de silicium est formée en carbure de silicium monocristallin.

Il est précisé que dans le cadre de la présente invention, le terme « électriquement conducteur » signifie que la partie correspondante, notamment une couche ou une succession de couches, présente un niveau de conductivité électrique suffisant pour avoir une fonction de passage électricité efficace dans une application donnée. Avantageusement, selon l'invention, l'ensemble du premier élément et/ou du deuxième élément/du dispositif résultant est électriquement conducteur. Notamment, on peut produire une conductivité électrique satisfaisante entre le matériau du substrat et la couche de carbure de silicium.

Il est précisé que dans le cadre de la présente invention, les termes « sur », « surmonte », « recouvre » ou « sous-jacent » ou leurs équivalents ne signifient pas forcément « au contact de ». Ainsi par exemple, le dépôt d'une première couche sur une deuxième couche, ne signifie pas obligatoirement que les deux couches sont directement au contact l'une de l'autre, mais cela signifie que la première couche recouvre au moins partiellement la deuxième couche en étant soit directement à son contact soit en étant séparée d'elle par au moins une autre couche ou au moins un autre élément.

Une couche peut par ailleurs être composée de plusieurs sous-couches d'un même matériau ou de matériaux différents.

Par composant, dispositif ou élément de dispositif microélectronique, on entend tout type d'élément réalisé avec les moyens de la microélectronique. Ces dispositifs englobent notamment en plus des dispositifs à finalité purement électronique, des dispositifs micromécaniques ou électromécaniques (MEMS, NEMS...) ainsi que des dispositifs optiques ou optoélectroniques (MOEMS...).

On parlera préférentiellement d'épaisseur pour une couche, de hauteur pour un dispositif ou un élément. L'épaisseur est prise selon une direction normale au plan d'extension principal de la couche, tout comme la hauteur.

Pour déterminer la disposition des différentes couches, on peut procéder à des analyses de microscopie électronique, en particulier de Microscopie Electronique à Balayage (MEB) ou de Microscopie Electronique en Transmission (MET ou TEM).

Les compositions chimiques des différentes couches ou régions peuvent être déterminées à l'aide de la méthode bien connue EDX ou X-EDS, acronyme de « energy dispersive x-ray spectroscopy » qui signifie « analyse dispersive en énergie de photons X », ou encore par une spectroscopie des pertes d'énergie (connue sous l'acronyme EELS, et correspondant à la traduction de « Electron Energy Loss Spectroscopy »), ou encore par la méthode XRD utilisant la réfraction de rayons X, la méthode SIMS de spectrométrie de masse des ions secondaires, ou encore la méthode RBS de spectroscopie de rétrodiffusion de Rutherford.

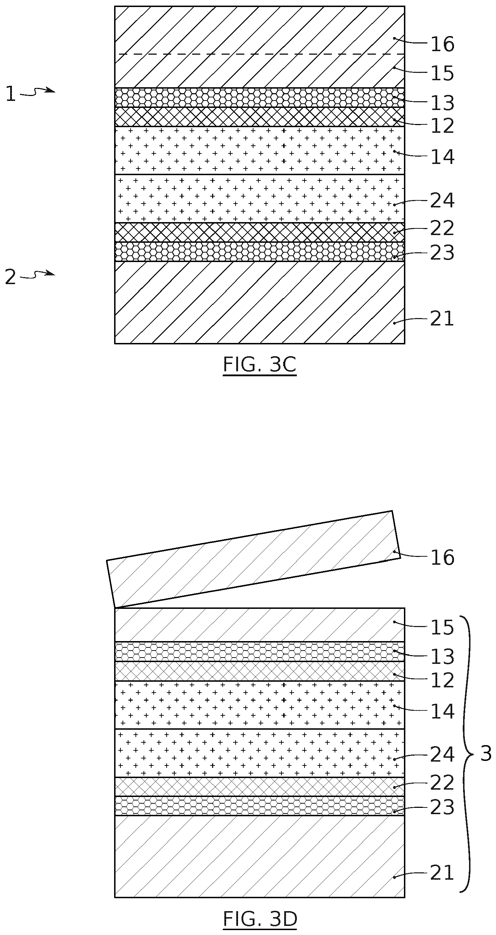

D'une manière générale, la présente invention cherche à réaliser un dispositif électronique 3 comportant, par exemple, la structure révélée par la figure 3D. Le dispositif 3 peut éventuellement faire l'objet d'autres transformations pour constituer un système final, ce qui signifie que d'autres éléments que les empilements ici décrits peuvent y être ajoutés.

Une première partie de l'empilement est un substrat 21. Il s'agira d'un matériau semi-conducteur, et de préférence du carbure de silicium, avantageusement polycristallin. On pourra cependant aussi utiliser du silicium, notamment polycristallin, à condition que le budget thermique impliqué par la fabrication soit inférieur à la température de fusion du silicium, c'est-à-dire environ 1400 °C ; cependant, si une reprise d'épitaxie est à faire, le budget thermique risque d'être trop important pour choisir ce matériau.

Sur une première face du substrat 21, l'empilement du dispositif 3 comporte une portion intermédiaire dont la structure sera décrite plus en détail ci-après. Globalement, on notera qu'elle comporte une couche métallique enterrée faite de tungstène.

La portion intermédiaire est recouverte, à l'opposé du substrat 21, par une couche 15 de carbure de silicium. De préférence, il s'agit de carbure de silicium monocristallin ; il peut s'agir de 4H-SiC.

Un tel dispositif 3 peut être obtenu par un procédé mettant en oeuvre un collage entre deux éléments 1, 2 présentant chacun une couche métallique de tungstène opérant en tant qu'interface de collage.

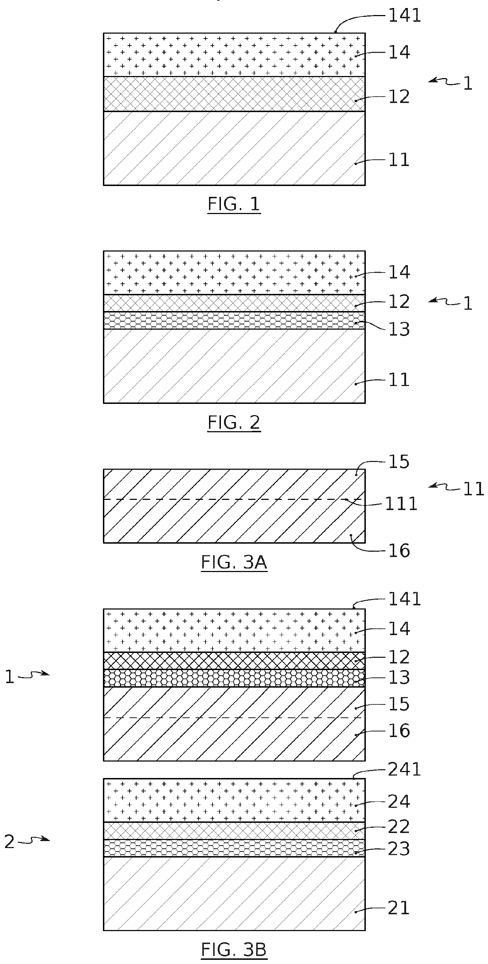

Dans ce contexte, la figure 1 montre un premier mode de réalisation d'un premier élément 1. Celui-ci comprend une couche primaire 11 destinée à former la couche 15 de carbure de silicium du dispositif résultant. À titre purement indicative, l'épaisseur de la couche primaire 11 peut être supérieure à 300 microns et/ou inférieure à 400 microns, et notamment égale à 350 microns. La couche primaire est surmontée d'une couche de siliciure de tungstène, du W₅Si₃ dans le cas d'espèce. Son épaisseur peut être comprise entre 5 nm et 20 nm. Elle peut être obtenue par un dépôt par pulvérisation, et notamment une co-pulvérisation de W et de Si dans des proportions molaires adéquates. Cette technique a l'avantage d'éviter un couple de diffusion métal/silicium et la siliciuration par interdiffusion est évitée. Suivant une variante, on utilise une pulvérisation d'un mélange de W et de Si.

Ce type de siliciure de tungstène peut être privilégié pour la stabilité à haute température.

La couche 14 de la figure 1 est une couche de tungstène, pure. Notamment, l'épaisseur de cette couche peut-être d'au moins 20 nm et/ou au plus de 100 nm. Elle peut être obtenue par pulvérisation.

Dans une variante, la couche de siliciure de tungstène 12 est faite de WSi₂. Dans cette solution, la couche barrière ainsi réalisée n'est pas en équilibre thermodynamique avec le tungstène pur. On peut anticiper qu'il y aura une formation de W₅Si₃ à l'interface entre le tungstène et la couche barrière à partir de températures de l'ordre de 800°C. Cependant, même si de telles températures sont atteintes, cette formation peut être tolérée, car la croissance de cette phase peut être contrôlée de sorte à maîtriser son épaisseur.

Un autre mode de réalisation du premier élément 1 est représenté à la figure 2. L'empilement de cet élément comprend alors une couche de siliciure de tungstène supplémentaire, à savoir une couche de WSi₂ qui se trouve intercalée entre carbure de silicium et la couche de siliciure précédemment décrites.

En termes d'épaisseur et de conditions de fabrication, les paramètres de la couche de WSi₂ peuvent être équivalents à ceux donnés pour la couche de W₅Si₃.

En ce qui concerne le deuxième élément électronique 2, la réalisation peut suivre l'un des exemples donnés ci-dessus en référence au premier élément 1. Simplement, la base de l'empilement est alors le substrat 21.

Les figures suivantes, de la figure 3A à 3D, montrent des étapes successives potentielles pour obtenir le dispositif de l'invention et mettre en oeuvre le procédé.

À la figure 3A, la couche primaire 11 du premier élément 1 fait l'objet d'une implantation ionique, par exemple jusqu'à viser une zone à une profondeur de 300 nm relativement à la surface de la couche primaire. La portion où les espèces implantées se concentrent forme une zone de fragilisation 111. On comprend que la profondeur d'implantation va déterminer l'épaisseur de la couche de carbure de silicium résultante. D'une manière générale, elle peut être inférieure à 500 nm, et par exemple comprise entre 450 et 500 nanomètres.

La figure 3B illustre la formation des empilements des éléments 1 et 2, pouvant adopter les exemples précédemment décrits.

On procède ensuite à l'assemblage des éléments 1 et 2 en mettant en contact les faces exposées 141, 241 de la couche de tungstène 14, 24, respectivement, du premier élément 1 et du deuxième élément 2. Un collage utilisant la technique d'un collage direct est approprié. Il est configuré pour être électriquement conducteur. On pourra mettre en oeuvre un collage direct avec activation de surface (de l'anglais Surface Activated Surface), connu sous l'acronyme SAB. Selon cette technique, un plasma, en particulier d'argon, est appliquée sur les faces à assembler.

Avantageusement, ce collage permet de créer une liaison inter atomique à température ambiante et sans ajout de matière adhésive. En outre, l'activation de surface permet de manière incidente une désoxydation des surfaces 141, 241.

Après le collage, l'assemblage peut être recuit, par exemple à une température comprise entre 800° et 900°C ; ce recuit est avantageusement configuré pour produire un clivage de la zone de fragilisation 111. La désolidarisation créée à ce niveau est schématisée à la figure 3D avec la libération de la portion 16 de la couche primaire. De préférence, mais pas forcément, ce traitement thermique sert aussi à la formation de la ou des couches de siliciure de tungstène, en faisant aussi office de recuit après pulvérisation, en particulier dans le cas d'un empilement SiC/WSi₂/W. Un traitement thermique complémentaire ou alternatif juste après co-pulvérisation est possible.

Le reste des empilements ainsi assemblés reste avantageusement en place pour former le dispositif 3. Ce dernier comporte donc ainsi successivement :
- le substrat 21 ;
- une couche de WSi₂ 23 ;
- une couche de W₅Si₃ 22 ;
- une couche globale de tungstène formée des couches initiales 14, 24 ;
- une couche de W₅Si₃ 12 ;
- une couche de WSi₂ 13 ;
- la couche de carbure de silicium 15.

Grâce à l'invention, on peut mettre en oeuvre des dispositifs à base de carbure de silicium, très avantageux compte tenu de leur capacité à travailler dans des conditions extrêmes de température et de radiation, tout en disposant d'un niveau de conductivité électrique élevé.

L'invention n'est pas limitée aux modes de réalisations précédemment décrits et s'étend à tous les modes de réalisation couverts par les revendications.

## Revendications

1. Procédé de fabrication d'un dispositif électronique(3) comportant en empilement un substrat (21) en matériau semi-conducteur, une portion intermédiaire et une couche de carbure de silicium (15), le procédé comprenant un transfert de la couche de carbure de silicium (15) depuis un premier élément (1) électronique sur une face d'un deuxième élément (2) électronique comprenant le substrat, le transfert comprenant :
- une fourniture du premier élément (1) comprenant en empilement une couche primaire (11) à base de carbure de silicium, une première portion de barrière de diffusion et une première couche métallique (14) ;
- une fourniture du deuxième élément (2) comprenant en empilement le substrat (21), une deuxième portion de barrière de diffusion et une deuxième couche métallique (24) ;
- un collage d'une face exposée de la première couche métallique (14) et d'une face exposée de la deuxième couche métallique (24),
**caractérisée en ce que en ce que** :
- la première couche métallique (14) et la deuxième couche métallique (24) sont formées en tungstène;
- la première portion est formée d'au moins une couche (12, 13) d'un siliciure de tungstène ;
- la deuxième portion est formée d'au moins une couche (22, 23) d'un siliciure de tungstène,
la deuxième portion de barrière de diffusion, la deuxième couche métallique, la première couche métallique (14) et la première portion de barrière de diffusion formant la portion intermédiaire.

2. Procédé selon la revendication précédente, dans lequel au moins une des couches de siliciure de tungstène est une couche d'un matériau choisi parmi du WSi₂ et du W₅Si₃.

3. Procédé selon l'une quelconque des revendications précédentes, dans lequel la première portion est formée au moins d'une couche de W₅Si₃ (12).

4. Procédé selon la revendication précédente, dans lequel la couche de W₅Si₃ (12) de la première portion est au contact de la première couche métallique (14).

5. Procédé selon l'une des deux revendications précédentes, dans lequel la première portion est aussi formée d'une couche de WSi₂ (13) entre la couche primaire (11) et la couche de W₅Si₃ (12) de la première portion.

6. Procédé selon l'une quelconque des revendications précédentes dans lequel la deuxième portion est formée au moins d'une couche de W₅Si₃ (22).

7. Procédé selon la revendication précédente, dans lequel la couche de W₅Si₃ (22) de la deuxième portion est au contact de la deuxième couche métallique (24).

8. Procédé selon l'une des deux revendications précédentes, dans lequel la deuxième portion est aussi formée d'une couche de WSi₂ (23) entre le substrat (21) et la couche de W₅Si₃ (22) de la deuxième portion.

9. Procédé selon l'une quelconque des revendications précédentes, dans lequel au moins une couche d'un siliciure de tungstène d'au moins l'une parmi la première portion et la deuxième portion est formée par co-pulvérisation de molécules de W et de molécules de Si.

10. Procédé selon l'une quelconque des revendications précédentes, dans lequel le collage comprend un collage direct avec activation de surface, et de préférence dans lequel l'activation de surface est configurée pour désoxyder, au moins partiellement, la face exposée (141) d'au moins l'une parmi la première couche métallique (14) et la deuxième couche métallique (24).

11. Procédé selon l'une quelconque des revendications précédentes, dans lequel le substrat (21) est en carbure de silicium.

12. Procédé selon l'une quelconque des revendications précédentes, comprenant la formation d'une zone de fragilisation (111) dans la couche primaire par une implantation d'espèces chimiques et, après le collage, un clivage de la couche primaire au niveau de la zone de fragilisation (111) par application d'un recuit.

13. Dispositif électronique (3) comprenant en empilement un substrat (21) à base de matériau semi-conducteur, une portion intermédiaire, et une couche à base de carbure de silicium (15), **caractérisé par** la portion intermédiaire comprenant successivement au moins une première couche de siliciure de tungstène, une couche de tungstène et au moins une deuxième couche de siliciure de tungstène.

14. Dispositif (3) selon la revendication précédente, dans lequel au moins l'une parmi l'au moins une première couche de siliciure de tungstène et l'au moins une deuxième couche de siliciure de tungstène comprend une couche de WSi₂ et une couche de W₅Si₃.

## Patentansprüche

1. Verfahren zur Erstellung einer elektronischen Vorrichtung (3), die einen Stapel aus einem Substrat (21) aus Halbleitermaterial, einen Zwischenabschnitt und eine Schicht aus Siliciumcarbid (15) beinhaltet, wobei das Verfahren eine Übertragung der Schicht aus Siliciumcarbid (15) von einem ersten elektronischen Element (1) auf eine Fläche eines zweiten elektronischen Elements (2) umfasst, das das Substrat umfasst, wobei die Übertragung umfasst:
- ein Bereitstellen des ersten Elements (1), das einen Stapel aus einer Primärschicht (11) umfasst, die auf Siliciumcarbid basiert, einen ersten Diffusionsbarrierenabschnitt und eine erste Metallschicht (14);
- ein Bereitstellen des zweiten Elements (2), das einen Stapel aus dem Substrat (21) umfasst, einen zweiten Diffusionsbarrierenabschnitt und eine zweite Metallschicht (24);
- ein Verkleben einer freigelegten Fläche der ersten Metallschicht (14) und einer freigelegten Fläche der zweiten Metallschicht (24),
**dadurch gekennzeichnet, dass**:
- die erste Metallschicht (14) und die zweite Metallschicht (24) aus Wolfram gebildet sind;
- der erste Abschnitt aus mindestens einer Schicht (12, 13) eines Wolframsilicids gebildet ist;
- der zweite Abschnitt aus mindestens einer Schicht (22, 23) eines Wolframsilicids gebildet ist,
wobei der zweite Diffusionsbarrierenabschnitt, die zweite Metallschicht, die erste Metallschicht (14) und der erste Diffusionsbarrierenabschnitt den Zwischenabschnitt bilden.

2. Verfahren nach dem vorhergehenden Anspruch, wobei mindestens eine der Wolframsilicidschichten eine Schicht aus einem Material ist, das aus WSi₂ und W₅Si₃ ausgewählt ist.

3. Verfahren nach einem der vorhergehenden Ansprüche, wobei der erste Abschnitt mindestens aus einer Schicht aus W₅Si₃ (12) gebildet ist.

4. Verfahren nach dem vorhergehenden Anspruch, wobei die Schicht aus W₅Si₃ (12) des ersten Abschnitts mit der ersten Metallschicht (14) in Kontakt steht.

5. Verfahren nach einem der zwei vorhergehenden Ansprüche, wobei der erste Abschnitt auch von einer Schicht aus WSi₂ (13) zwischen der Primärschicht (11) und der Schicht aus W₅Si₃ (12) des ersten Abschnitts gebildet ist.

6. Verfahren nach einem der vorhergehenden Ansprüche, wobei der zweite Abschnitt mindestens aus einer Schicht aus W₅Si₃ (22) gebildet ist.

7. Verfahren nach dem vorhergehenden Anspruch, wobei die Schicht aus W₅Si₃ (22) des zweiten Abschnitts mit der zweiten Metallschicht (24) in Kontakt steht.

8. Verfahren nach einem der zwei vorhergehenden Ansprüche, wobei der zweite Abschnitt auch von einer Schicht aus WSi₂ (23) zwischen dem Substrat (21) und der Schicht aus W₅Si₃ (22) des zweiten Abschnitts gebildet ist.

9. Verfahren nach einem der vorhergehenden Ansprüche, wobei mindestens eine Wolframsilicidschicht von mindestens einem des ersten Abschnitts und des zweiten Abschnitts durch Co-Sputtern von W-Molekülen und Si-Molekülen gebildet ist.

10. Verfahren nach einem der vorhergehenden Ansprüche, wobei die Verklebung eine direkte Verklebung mit Oberflächenaktivierung umfasst, und wobei vorzugsweise die Oberflächenaktivierung konfiguriert ist, um mindestens teilweise die freigelegte Fläche (141) von mindestens einer der ersten Metallschicht (14) und der zweiten Metallschicht (24) zu desoxidieren.

11. Verfahren nach einem der vorhergehenden Ansprüche, wobei das Substrat (21) ein Siliciumcarbid ist.

12. Verfahren nach einem der vorhergehenden Ansprüche, die Bildung einer Versprödungszone (111) in der Primärschicht umfassend durch eine Implantation chemischer Spezies, und, nach dem Verkleben, eine Spaltung der Primärschicht im Bereich der Versprödungszone (111) durch das Anwenden von Glühen.

13. Elektronische Vorrichtung (3), einen Stapel aus einem Substrat (21) umfassend, das auf einem Halbleitermaterial basiert, einen Zwischenabschnitt und eine Schicht, die auf Siliciumcarbid (15) basiert, **dadurch gekennzeichnet, dass** der Zwischenabschnitt nacheinander mindestens eine erste Schicht aus Wolframsilicid umfasst, eine Schicht aus Wolfram und mindestens eine zweite Schicht aus Wolframsilicid.

14. Vorrichtung (3) nach dem vorhergehenden Anspruch, wobei mindestens eine von mindestens einer ersten Schicht aus Wolframsilicid und mindestens einer zweiten Schicht aus Wolframsilicid eine Schicht aus WSi₂ und eine Schicht aus W₅Si₃ umfasst.

## Claims

1. A method for manufacturing an electronic device (3) including in stack a substrate (21) made of semiconductor material, an intermediate portion and a silicon carbide layer (15), the method comprising a transfer of the silicon carbide layer (15) from a first electronic element (1) onto a face of a second electronic element (2) comprising the substrate, the transfer comprising:
- providing the first element (1) comprising in stack a primary silicon carbide-based layer (11), a first diffusion barrier portion and a first metal layer (14);
- providing the second element (2) comprising in stack the substrate (21), a second diffusion barrier portion and a second metal layer (24);
- bonding an exposed face of the first metal layer (14) and an exposed face of the second metal layer (24),
**characterised in that**:
- the first metal layer (14) and the second metal layer (24) are formed of tungsten;
- the first portion is formed of at least one tungsten silicide layer (12, 13);
- the second portion is formed of at least one tungsten silicide layer (22, 23),
the second diffusion barrier portion, the second metal layer, the first metal layer (14) and the first diffusion barrier portion forming the intermediate portion.

2. The method according to the preceding claim, wherein at least one of the tungsten silicide layers is a layer of a material selected from WSi₂ and W₅Si₃.

3. The method according to any one of the preceding claims, wherein the first portion is formed of at least one W₅Si₃ layer (12).

4. The method according to the preceding claim, wherein the W₅Si₃ layer (12) of the first portion is in contact with the first metal layer (14).

5. The method according to one of the two preceding claims, wherein the first portion is also formed of a WSi₂ layer (13) between the primary layer (11) and the W₅Si₃ layer (12) of the first portion.

6. The method according to any one of the preceding claims wherein the second portion is formed of at least one W₅Si₃ layer (22).

7. The method according to the preceding claim, wherein the W₅Si₃ layer (22) of the second portion is in contact with the second metal layer (24).

8. The method according to one of the two preceding claims, wherein the second portion is also formed of a WSi₂ layer (23) between the substrate (21) and the W₅Si₃ layer (22) of the second portion.

9. The method according to any one of the preceding claims, wherein at least one tungsten silicide layer of at least one of the first portion and the second portion is formed by co-sputtering W molecules and Si molecules.

10. The method according to any one of the preceding claims, wherein the bonding comprises a direct bonding with surface activation, and preferably wherein the surface activation is configured to deoxidise, at least partially, the exposed face (141) of at least one of the first metal layer (14) and the second metal layer (24).

11. The method according to any one of the preceding claims, wherein the substrate (21) is made of silicon carbide.

12. The method according to any one of the preceding claims, comprising the formation of a weakening area (111) in the primary layer by implantation of chemical species and, after bonding, a cleavage of the primary layer at the weakening area (111) by application of an annealing.

13. An electronic device (3) comprising in stack a substrate (21) based on semiconductor material, an intermediate portion, and a silicon carbide-based layer (15), **characterised by** the intermediate portion successively comprising at least a first tungsten silicide layer, a tungsten layer and at least a second tungsten silicide layer.

14. The device (3) according to the preceding claim, wherein at least one of the at least one first tungsten silicide layer and the at least one second tungsten silicide layer comprises a WSi₂ layer and a W₅Si₃ layer.
